# EUROPÄISCHE PATENTSCHRIFT

(11) **EP 2 232 652 B1**
(45) Veröffentlichungstag und Bekanntmachung des Hinweises auf die Patenterteilung: **28.03.2018**
(21) Anmeldenummer: 08871567.7
(22) Anmeldetag: 20.11.2008
(51) Int. Cl.: H01R 43/02, H01R 43/20, H01R 13/506, H01R 13/53, H01R 12/71, H01R 13/504

(54) **STECKVERBINDERTEIL, STECKVERBINDUNG, GERÄT UND VERFAHREN ZUR HERSTELLUNG EINES GERÄTS**
PLUG CONNECTOR PART, PLUG CONNECTION, DEVICE AND METHOD FOR THE PRODUCTION OF A DEVICE
PARTIE CONNECTEUR ENFICHABLE, CONNEXION ENFICHABLE, APPAREIL ET PROCÉDÉ DE FABRICATION D'UN APPAREIL

(30) Priorität: 23.01.2008 DE 102008005776
(43) Veröffentlichungstag der Anmeldung: 29.09.2010
(73) Patentinhaber: SEW-Eurodrive GmbH & Co, 76646 Bruchsal (DE)
(72) Erfinder: ENDERLE, Christian, 76689 Karlsdorf-Neuthard (DE); MÜLLER, Michael, 76185 Karlsruhe (DE); SIMON, Olaf, 76646 Bruchsal (DE)
(86) Internationale Anmeldenummer: PCT/EP2008/009798
(87) Internationale Veröffentlichungsnummer: WO 2009/092413

(56) Entgegenhaltungen:
- EP-A- 1 780 837
- EP-A2- 1 289 075
- AT-B- 366 514
- DE-A1- 19 757 938

## Beschreibung

Die Erfindung betrifft ein Steckverbinderteil, eine Steckverbindung, ein Gerät und ein Verfahren zur Herstellung eines Geräts.

Es ist allgemein bekannt, dass ein Kunststoffteil eines Steckverbinderteils Anschlussstifte aufnimmt, die lötverbindbar sind mit Lötpads, also Leiterbahnen, einer Leiterplatte.

Aus der EP 1 780 837 A2 ist eine Anschlusseinrichtung für eine Leiterplatte bekannt, wobei ein die Luftstrecke vergrößernder Isolierkörper durch Verrasten mit der die Anschlussstifte aufnehmenden Leiterplatte verbindbar ist..

Aus der AT 366 514 B ist ein elektrisches Verbindungselement bekannt, wobei ein Rundsteckverbinder mit einem metallischen Außengehäuse und einem isolierenden Teil gezeigt ist, in welchem Anschlussstifte aufgenommen sind.

Aus der DE 197 57 938 A1 ist ein Isolationskamm für Multikontaktstecker bekannt, wobei ein von einem Steckerteil getrenntes Isolierteil zur Vergrößerung einer Luftstrecke zwischen Anschlussstiften gezeigt ist, die im Steckerteil aufgenommen sind.

Aus der EP 1 289 075 A2 ist ein Steckverbinder mit Isolations- und Dichtungselement bekannt.

Der Erfindung liegt daher die Aufgabe zugrunde, ein Elektrogerät kompakt zu gestalten.

Erfindungsgemäß wird die Aufgabe bei dem Steckverbinderteil nach den in Anspruch 1, bei dem Gerät nach den in Anspruch 9 und bei dem Verfahren nach den in Anspruch 13 angegebenen Merkmalen gelöst.

Wichtige Merkmale der Erfindung bei dem Steckverbinderteil sind, dass es ein isolierendes Teil umfasst, insbesondere Kunststoffteil, an dem eine Ausnehmung, insbesondere zweite Ausnehmung, ausgeformt ist,
wobei in dem isolierenden Teil Anschlussstifte aufgenommen sind,
wobei ein Isolierkörper in die Ausnehmung des isolierenden Teils verbindbar ist zur Vergrößerung der Luftstrecke zwischen den Anschlussstiften,
wobei ein Isolierkörper in die Ausnehmung des isolierenden Teils verbindbar ist zur Vergrößerung der Luftstrecke zwischen den Anschlussstiften,
wobei der Isolierkörper in die Ausnehmung des isolierenden Teils einklipsbar und/oder kraftschlüssig verbindbar ist.

Von Vorteil ist dabei, dass das Kunststoffteil des Steckverbinderteils samt Anschlussstiften mittels Standard-Lötprozess lötverbindbar ist mit den Leiterbahnen einer Leiterplatte. Erst danach ist der Isolierkörper vorteiligerweise hinzugefügt, wodurch Lötschattenbildung durch den Isolierkörper beim Löten verhindert ist. Außerdem ist eine besonders kompakte Steckverbindung geschaffen. Des Weiteren ist mit der Ausformung der Ausnehmung eine Codierung erzeugbar, so dass nur ein bestimmungsgemäßes Verbinden des Isolierkörpers mit dem Kunststoffteil ermöglicht ist.

Bei einer vorteilhaften Ausgestaltung ist das isolierende Teil mit einem metallischen Steckergehäuseteil verbindbar, insbesondere einklipsbar, und von diesem zumindest teilweise gehäusebildend umgeben ist. Von Vorteil ist dabei, dass ein einfaches und schnelles Herstellen der Verbindung erreichbar ist.

Bei einer vorteilhaften Ausgestaltung ist das metallische Steckergehäuseteil mit einem entsprechenden metallischen Steckergehäuseteil eines Gegensteckverbinders verbindbar, insbesondere schraubverbindbar. Von Vorteil ist dabei, dass eine dichte und auch elektrische Verbindung in einfacher Weise, beispielsweise durch Schrauben herstellbar ist.

Bei einer vorteilhaften Ausgestaltung ist das metallische Steckergehäuseteil geerdet vorgesehen, insbesondere zur hochfrequenzmäßigen Abschirmung und/oder Erhöhung der Sicherheit. Von Vorteil ist dabei, dass bei Ausführung des Kabels als Hybridkabel, also integriert umfassend Leistungsleitungen, wie Starkstromleitungen, und Niederspannungsleitungen, wie Datenleitungen und/oder Signalleitungen, eine gute Abschirmung und somit eine ungestörte oder nur wenig gestörte Datenübertragung ermöglicht ist.

Bei einer vorteilhaften Ausgestaltung ist das Steckverbinderteil zur Verbindung mit einem Gegensteckverbinderteil ausgeführt, insbesondere als Buchse. Von Vorteil ist dabei, dass ein Berührschutz in einfacher Weise realisierbar ist.

Bei einer vorteilhaften Ausgestaltung ist das metallische Steckergehäuseteil in ein Gerätegehäuse einschraubbar, insbesondere zur Erdverbindung in ein metallisches **Gehäuseteil.** Von Vorteil ist dabei, dass eine gute Abschirmung und Erdverbindung einfach und leicht herstellbar ist.

**Erfindungsgemäß** ist der Isolierkörper in die Ausnehmung des isolierenden Teils einklipsbar und/oder kraftschlüssig verbindbar. Von Vorteil ist dabei, dass eine einfache Verbindung schnell und sicher herstellbar ist.

Wichtige Merkmale der Erfindung bei der Steckverbindung sind, dass sie ein Steckverbinderteil in vorgenannter Weise umfasst. Von Vorteil ist dabei, dass eine dichte und abgeschirmte Verbindung herstellbar ist.

Bei einer vorteilhaften Ausgestaltung ist die Steckverbindung als beidseitig berührgeschützte Rundsteckverbindung ausgeführt. Von Vorteil ist dabei, dass die Sicherheit erhöhbar ist. Außerdem ist die Verbindung wegen des vom Lochbild zumindest umfassten kreisrunden Lochbildes kompakt vorsehbar.

Wichtige Merkmale der Erfindung bei dem Gerät sind, dass es ein Steckverbinderteil umfasst,
**das ein isolierendes Teil umfasst, insbesondere ein Kunststoffteil, an dem eine Ausnehmung, insbesondere zweite Ausnehmung, ausgeformt ist,**
**wobei in dem isolierenden Teil Anschlussstifte aufgenommen sind, wobei die Anschlussstifte lötverbindbar mit Lötpads einer Leiterplatte sind,**
**wobei ein Isolierkörper in die Ausnehmung des isolierenden Teils eingesteckt vorgesehen ist zur Vergrößerung der Luftstrecke zwischen den Anschlussstiften,**
**wobei der Isolierkörper durch eine Leiterplatte hindurchragt, mit welcher das Steckverbinderteil zumindest lötverbunden ist,**
**wobei der Isolierkörper in die Ausnehmung des isolierenden Teils einklipsbar und/oder kraftschlüssig verbindbar ist.**

Von Vorteil ist dabei, dass die Abstände der Anschlussstifte derart gering und somit die Steckverbindung derart kompakt wählbar ist, dass ohne den nachträglich eingebrachten Isolierkörper ein elektrischer Durchschlag zu befürchten ist, insbesondere bei den vorgesehenen Spannungen von mehr als 300 Volt oder sogar bis zu 1000 Volt. Somit ist sogar die Zwischenkreisspannung netzgespeister Umrichter mittels des Kabels übertragbar. Alternativ ist die Netzspannung selbst durchleitbar.

Bei einer **nicht erfindungsgemäßen** Ausgestaltung ragt der Isolierkörper durch eine Leiterplatte hindurch, mit welcher das Steckverbinderteil zumindest lötverbunden ist. Von Vorteil ist dabei, dass er von der vom Steckverbinderteil abgewandten Seite der Leiterplatte einführbar ist durch eine Ausnehmung der Leiterplatte in eine Ausnehmung im Kunststoffteil. Somit ist durch die Ausführung der Ausnehmungen ein bestimmungsgemäßes Einführen des Isolierkörpers erzwingbar und somit die Sicherheit erhöhbar.

Bei einer vorteilhaften Ausgestaltung ist Material des Isolierkörpers zwischen zueinander benachbarten Anschlussstiften, insbesondere zueinander nächstbenachbarten Anschlussstiften, vorgesehen. Von Vorteil ist dabei, dass die Luftstrecken somit vergrößert sind und somit Kriechstrecken für die zugehörigen Spannungswerte eingehalten sind.

Bei einer vorteilhaften Ausgestaltung ist der Isolierkörper durch die Ausnehmung in der Leiterplatte nach Ausführen der Lötverbindung zwischen Leiterplatte und Steckverbinderteil gesteckt. Von Vorteil ist dabei, dass ein Lötschatten verhinderbar ist. Außerdem ist ein Kunststoffmaterial im Isolierkörper verwendbar, das eine niedrigere Schmelztemperatur aufweist als die beim Löten herrschenden Temperaturen.

Bei einer vorteilhaften Ausgestaltung ist das Gehäuse des Geräts metallisch und das Steckverbinderteil umfasst ein mit dem Gerätegehäuse verbundenes metallisches Steckergehäuseteil. Von Vorteil ist dabei, dass eine Herstellung einer Erdverbindung für das Gehäuseteil einfach vorsehbar ist.

Bei einer vorteilhaften Ausgestaltung ist in das Steckverbinderteil ein Gegensteckverbinderteil einsteckbar, das mit einem außengeschirmten Kabel verbindbar ist. Von Vorteil ist dabei, dass eine hochfrequenzmäßig verbesserte Abschirmung ermöglicht ist.

Bei einer vorteilhaften Ausgestaltung ist einer der Anschlussstifte des Steckverbinderteils mit dem metallischen Steckergehäuseteil elektrisch verbunden, insbesondere wobei dieser Anschlussstift weiter herausragt aus dem Steckverbinderteil als die anderen Anschlussstifte. Von Vorteil ist dabei, dass die Sicherheit erhöht ist, da ein Berührschutz ausführbar ist.

Bei einer vorteilhaften Ausgestaltung ist das Steckverbinderteil ein Hybridsteckverbinderteil. Von Vorteil ist dabei, dass Leistungsstrom und Signalströme führende Leitungen als gemeinsames Kabel verlegbar sind.

Bei einer vorteilhaften Ausgestaltung ist das Gerät ein Frequenzumrichter oder ein Elektromotor. Von Vorteil ist dabei, dass hohe Spannungen direkt am Gerätegehäuse direkt über die Steckverbindung an die Leiterplatte weiterführbar sind.

Bei einer vorteilhaften Ausgestaltung ist der Isolierkörper derart asymmetrisch geformt, dass er nur bestimmungsgemäß in die Ausnehmung im isolierenden Teil einführbar ist. Von Vorteil ist dabei, dass ein bestimmungsgemäßes Verbinden erzwingbar ist.

Bei einer vorteilhaften Ausgestaltung ist eine Unterbrechungsvorrichtung im Steckverbinderteil derart vorgesehen, dass der elektrische Kontakt der auf der Leiterplatte lötverbundenen Anschlussstifte zu Anschlussstiften eines mit dem Steckverbinderteil verbundenen Gegensteckverbinderteils unterbrochen ist, solange der Isolierkörper nicht in der Ausnehmung eingeführt und verbunden ist. Somit ist erst eine Spannungszufuhr freigegeben, wenn der Isolierkörper eingeschoben ist und somit die Luftstrecken erhöht sind. Auf diese Weise ist die Sicherheit erhöht. Die Unterbrechungsvorrichtung ist hierbei in mechanischer Weise vorsehbar, wobei beispielsweise nach Einstecken des Isolierkörpers die Federkraft einer Feder überwunden wird und auf diese Weise ein metallisches Kontaktteil in ein anderes einschiebbar ist und somit die Anschlussstifte Steckverbinderteils elektrisch verbindbar sind mit den Anschlussstiften des Gegensteckverbinderteils.

Weitere Vorteile ergeben sich aus den Unteransprüchen.

Die Erfindung wird nun anhand von Abbildungen näher erläutert:

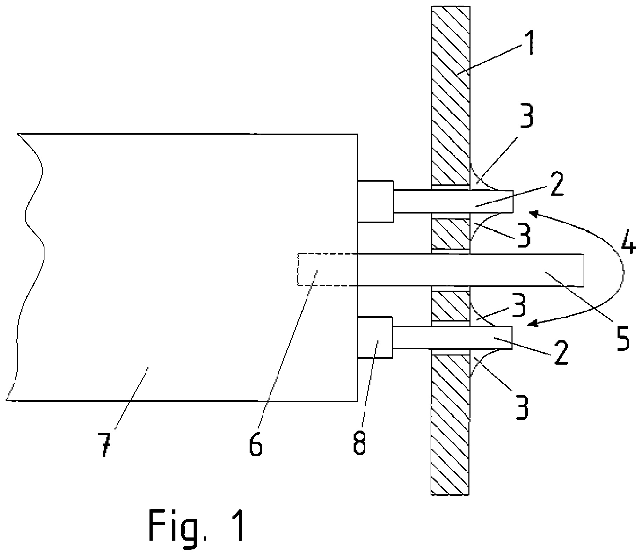

In der Figur 1 ist eine erfindungsgemäße Vorrichtung teilweise und nur schematisch in Schnittansicht skizziert.

Dabei wird ein Steckverbinderteil auf der Leiterplatte 1 verbunden. Das Steckverbinderteil ist beispielsweise als Buchse ausgeführt, so dass ein an einem Kabelende vorgesehenes weiteres Gegensteckverbinderteil, wie beispielsweise Stecker, in die Buchse einsteckbar ist und somit eine mechanische und elektrische Verbindung herstellbar ist, die von den elektrischen Leitungen des Kabels bis zu auf der Leiterplatte 1 vorgesehenen Leiterbahnen führt. In der erfindungsgemäßen Ausführung sind sogar starke Ströme durchleitbar mit mehr als 1 Ampere, insbesondere mit mehr als 10 Ampere.

Dabei umfasst das Steckverbinderteil metallische Anschlussstifte 2, die aus dem Kunststoffteil 7 des Steckverbindergehäuses des Steckverbinderteils herausragen und in erste Ausnehmungen der Leiterplatte gesteckt sind und dort auf der anderen Seite herausragen. Diese Anschlussstifte 2 sind mittels Lötzinn 3 verlötet mit Leiterbahnen der Leiterplatte 1.

Erst nach Ausführen des Aufbringens von Lötzinn 3, beispielsweise indem die Leiterplatte samt Steckverbinderteil durch ein Schwallbad gefahren wird und daher ein Schwalllötprozess durchgeführt wird, und somit nach dem Lötverbinden des Steckverbinderteils wird der Isolierkörper 5 von der anderen Seite her kommend durch eine zweite Ausnehmung der Leiterplatte 1 eingeführt und in das Steckverbinderteil eingesteckt. Auf diese Weise wird die Luftstrecke 4, also die kürzeste Verbindungsstrecke zwischen den Anschlussstiften 2 durch die Luft vergrößert.

Vorzugsweise ist die zweite Ausnehmung als Ausfräsung gefertigt. Es sind aber auch andere Fertigungsverfahren verwendbar, wie beispielsweise Laser-Bohrungen und dergleichen. Die Form der zweiten Ausnehmung ist der Ausnehmung 6 im Kunststoffteil 7 des Steckverbindergehäuses entsprechend geformt. Wenn die ersten Ausnehmungen für die Anschlussstifte beispielsweise auf einem Kreis angeordnet sind, wird die zweite Ausnehmung sternförmig ausgeführt, wobei die jeweiligen Strahlen des Sterns zwischen zwei jeweils nächstbenachbarten ersten Ausnehmungen angeordnet sind. Der Isolierkörper ist dann ebenfalls sternförmig ausgeführt.

Der Isolierkörper 5 selbst ist vorzugsweise aus einem elektrisch gut isolierenden Kunststoff gefertigt, der also eine hohe Durchschlagsfestigkeit aufweist.

Der Isolierkörper 5 wird durch eine entsprechende Ausnehmung in der Leiterplatte 1 hindurchgeführt und in eine Ausnehmung 6 zur Aufnahme des Isolierkörpers 5 eingesteckt.

Dass der Isolierkörper 5 erst nach dem Lötprozessschritt eingesetzt wird, ermöglicht, dass der Isolierkörper aus einem Kunststoff herstellbar ist, der nur unterhalb der beim Lötprozess auftretenden Temperaturen beständig ist. Somit ist ein kostengünstigeres und/oder ein Material mit höherer elektrischer Durchschlagfestigkeit wählbar. Außerdem wird beim Lötprozess kein Lötschatten geworfen und daher die Lötverbindung der Anschlussstifte schnell und einfach sowie mit hoher Qualität ausführbar.

Das Kunststoffteil 7 des Steckverbindergehäuses umfasst eine Isolierung und Aufnahme 8 für die Anschlussstifte 2, in der diese gehalten sind. Das Steckverbindergehäuse ist auf der von der Leiterplatte abgewandten Seite als Buchse ausgeführt, so dass ein Gegensteckverbinderteil einsteckbar ist.

Über die erfindungsgemäße Steckverbindung sind Leistungen von mehr als 1 kW oder sogar mehr als 10kW übertragbar. Wichtig ist auch, dass zwischen den Anschlussstiften hohe Potentialdifferenzen auftreten dürfen, die mehr als 500 Volt oder sogar mehr als 1000 Volt betragen. Mittels des nachträglich eingesteckten Isolierkörpers wird eine ausreichend hohe Luftstrecke erzwungen.

Besonderer Vorteil ist auch das einfache und kostengünstige Fertigen der Steckverbindung, insbesondere die einfache und schnelle Verbindungsmöglichkeit des Steckverbinders mit den Leiterbahnen der Leiterplatte.

Vorzugsweise ist die Ausnehmung 6 zur Aufnahme des Isolierkörpers 5 derart ausgeführt, dass dieser nur auf die vorgesehene Weise einführbar ist in die Aufnahme. Für eine solche Codierung ist eine asymmetrische Formgebung vorteilhaft.

Bei einem weiteren erfindungsgemäßen Ausführungsbeispiel sind die Ausnehmung 6 und der Isolierkörper 5 derart ausgeführt, dass der Isolierkörper formschlüssig, insbesondere mittels Einklipsen, und/oder kraftschlüssig verbindbar sind. Dabei ist die Verbindung lösbar oder auch nicht lösbar ausgeführt.

Bei einem weiteren erfindungsgemäßen Ausführungsbeispiel weist das Kabel einen Außenschirm auf, das im Gegensteckverbinderteil aufgelegt ist. Hierdurch wird auch eine hochfrequenzmäßig gute Abschirmung ermöglicht. Außerdem ist es ermöglicht die Abschirmleitung hochfrequenzmäßig gut anzubinden über die Steckverbindung an das metallische geerdete Gehäuseteil.

Bei einem weiteren erfindungsgemäßen Ausführungsbeispiel ist das Steckverbinderteil im Gehäuseteil eines die Leiterplatte umfassenden Geräts eingeschraubt. Hierzu umfasst das Steckverbinderteil ein in der Figur nicht gezeigtes metallisches Steckergehäuseteil, das schraubverbunden mit dem Gehäuseteil ist und in das ein die Anschlussstifte aufnehmendes Kunststoffteil formschlüssig verbindbar, insbesondere einklipsbar ist. Als Gerät ist ein Elektrogerät, wie beispielsweise ein Umrichter, eine dezentrale Steuerung oder ein Kompaktantrieb, der in seinem Gehäuse ein Getriebe, einen Elektromotor und einen Umrichter umfasst, oder auch nur ein Umrichtermotor, der in seinem Gehäuse einen Elektromotor und einen Umrichter umfasst, vorsehbar.

Wenn das Gehäuseteil des Geräts metallisch ist, ist dieses geerdet vorsehbar und somit ist das mit dem Gehäuseteil schraubverbundene metallische Steckergehäuseteil des Steckverbinderteils ebenfalls mit Erde verbindbar.

Bei einem weiteren erfindungsgemäßen Ausführungsbeispiel ist die Steckverbindung eine Hybridsteckverbindung, die Leistungsleitungen und Signalleitungen umfasst, welche auf unterschiedlichen Potentialen liegen und um mehr als den Faktor 100 verschieden große elektrische Stromwerte aufweisen. Dabei werden die Ströme über die unterschiedlichen Pins an unterschiedlich große Pads, also Leiterbahnen der Leiterplatte, übergeben, wobei die Pads größer sind als der Durchmesser der Anschlussstifte in der Leiterplattenebene. Somit ist der Abstand zwischen den Pads unterschiedlicher Potentiale kleiner als der Abstand zwischen den im Leiterplattenbereich zueinander parallel vorgesehenen Anschlussstiften.

Bei einem weiteren erfindungsgemäßen Ausführungsbeispiel ist die Steckverbindung berührgeschützt ausgeführt. Hierzu sind die Anschlussstifte, also Pins, des Steckverbinderteils und des Gegensteckverbinderteils jeweils berührgeschützt ausgeführt. Dies wird dadurch erreicht, dass die metallischen stromführenden Stifte derart versenkt in einem jeweiligen isolierenden Teil angeordnet sind, dass ein menschlicher Finger, insbesondere ein gemäß Norm ausgeführter Finger, keine Berührung der metallischen Teile ermöglicht. Vorzugsweise ist die Steckverbindung also als beidseitig berührgeschützte Rundsteckverbindung ausgeführt.

Bei einem weiteren erfindungsgemäßen Ausführungsbeispiel ist das Kabel mit einem Außenschirm ausgeführt, so dass eine Erdverbindung realisierbar ist, wobei allerdings die Erdverbindung einen größeren Leitungsquerschnitt aufweist als der größte Querschnitt einer Ader der elektrischen Leitungen zur Übertragung von Leistungsströmen.

Die Steckverbindung ist dabei so ausgeführt, dass beim Schließen die Erdverbindung zuerst und danach die weiteren Verbindungen vorgesehen ist. Beim Lösen der Steckverbindung wird entsprechend umgekehrt die Erdverbindung als Letztes getrennt. Vorzugsweise ist hierzu beim Steckverbinder und Gegensteckverbinder ein - entsprechend dem oben schon erwähnten - metallisches Steckergehäuseteil vorgesehen, die jeweils miteinander in elektrischen Kontakt bringbar sind, beispielsweise durch Schraubverbinden. Vorzugsweise sind die metallischen Steckergehäuseteile als Schraubhülsen ausgeführt, in die ein jeweiliges Kunststoffteil 7 einklipsbar ist.

Bei einem weiteren erfindungsgemäßen Ausführungsbeispiel ist mindestens einer der Anschlussstifte 2 oder Pins auf Erdpotential gelegt, um zusätzlich die Sicherheit zu erhöhen. Somit ist das Erdpotential auf die Leiterplatte führbar und zusätzlich über das Steckergehäuseteil an das Gehäuseteil des Geräts, wodurch eine direkte Anbindung des Außenschirms des Kabels an das Gerätegehäuse und somit Erde ausführbar ist. Vorzugsweise ist dieser Anschlussstift etwas länger ausgeführt und tritt somit beim Lösen der Steckverbindung als Letztes aus und wird beim Herstellen der Verbindung als Erstes kontaktiert.

Bei den erfindungsgemäßen Ausführungsbeispielen bilden die Anschlussstifte 2 ein Polbild, dem die Anordnung der ersten Ausnehmungen entspricht. Der Isolierkörper ist diesem Polbild entsprechend geformt, insbesondere also derart, dass Material des Isolierkörpers zwischen benachbarten Anschlussstiften anordenbar ist zur Vergrößerung der Luftstrecke zwischen diesen Anschlussstiften.

Unter Luftstrecke wird hier stets der kürzeste aller durch Luft führenden Wege zwischen einem der Oberflächenpunkte eines ersten Anschlussstiftes und einem der Oberflächenpunkte eines zweiten Anschlussstiftes.

### Bezugszeichenliste

1 Leiterplatte
2 Anschlussstift
3 Lötzinn
4 Luftstrecke zwischen Anschlussstiften
5 Isolierkörper
6 Ausnehmung zur Aufnahme des Isolierkörpers
7 Kunststoffteil des Steckverbindergehäuses
8 Isolierung und Aufnahme für Anschlussstift

## Patentansprüche

1. Steckverbinderteil,
umfassend ein isolierendes Teil (7), insbesondere Kunststoffteil, an dem eine Ausnehmung (6), insbesondere zweite Ausnehmung, ausgeformt ist,
wobei in dem isolierenden Teil Anschlussstifte (2) aufgenommen sind,
wobei die Anschlussstifte lötverbindbar mit Lötpads einer Leiterplatte (1) sind,
wobei ein Isolierkörper (5) in die Ausnehmung des isolierenden Teils verbindbar ist zur Vergrößerung der Luftstrecke (4) zwischen den Anschlussstiften (2),
**dadurch gekennzeichnet, dass**
der Isolierkörper (5) in die Ausnehmung des isolierenden Teils einklipsbar und/oder kraftschlüssig verbindbar ist.

2. Steckverbinderteil nach Anspruch 1,
wobei das isolierende Teil mit einem metallischen Steckergehäuseteil verbindbar ist, insbesondere einklipsbar, und von diesem zumindest teilweise gehäusebildend umgeben ist.

3. Steckverbinderteil nach Anspruch 2,
wobei das metallische Steckergehäuseteil mit einem entsprechenden metallischen Steckergehäuseteil eines Gegensteckverbinders verbindbar ist, insbesondere schraubverbindbar.

4. Steckverbinderteil nach Anspruch 2 oder 3,
wobei das metallische Steckergehäuseteil geerdet vorgesehen ist, insbesondere zur hochfrequenzmäßigen Abschirmung und/oder Erhöhung der Sicherheit.

5. Steckverbinderteil nach mindestens einem der vorangegangenen Ansprüche,
wobei das Steckverbinderteil auf der von der Leiterplatte abgewandten Seite zur Verbindung mit einem Gegensteckverbinderteil ausgeführt ist, insbesondere als Buchse.

6. Steckverbinderteil nach mindestens einem der Ansprüche 2 bis 4,
wobei das metallische Steckergehäuseteil in ein Gerätegehäuse einschraubbar ist, insbesondere zur Erdverbindung in ein metallisches Gehäuseteil.

7. Steckverbindung
**dadurch gekennzeichnet, dass**
sie ein Steckverbinderteil nach mindestens einem der vorangegangenen Ansprüche umfasst.

8. Steckverbindung nach dem vorangegangenen Anspruch,
**dadurch gekennzeichnet, dass**
die Steckverbindung als beidseitig berührgeschützte Rundsteckverbindung ausgeführt ist.

9. Gerät, umfassend ein Steckverbinderteil ,
das ein isolierendes Teil umfasst, insbesondere ein Kunststoffteil, an dem eine Ausnehmung, insbesondere zweite Ausnehmung, ausgeformt ist,
wobei in dem isolierenden Teil Anschlussstifte (2) aufgenommen sind, wobei die Anschlussstifte lötverbindbar mit Lötpads einer Leiterplatte (1) sind,
wobei
ein Isolierkörper (5) in die Ausnehmung des isolierenden Teils eingesteckt vorgesehen ist zur Vergrößerung der Luftstrecke (4) zwischen den Anschlussstiften (2),
wobei der Isolierkörper (5) durch eine Leiterplatte (1) hindurchragt, mit welcher das Steckverbinderteil zumindest lötverbunden ist,
**dadurch gekennzeichnet, dass**
der Isolierkörper (5) in die Ausnehmung (6) des isolierenden Teils (7) einklipsbar und/oder kraftschlüssig verbindbar ist.

10. Gerät nach Anspruch 9,
wobei Material des Isolierkörpers (5) zwischen zueinander benachbarten Anschlussstiften (2), insbesondere zueinander nächstbenachbarten Anschlussstiften (2), vorgesehen ist, und/oder dass
das Steckverbinderteil nach einem der Ansprüche 1 bis 6 ausgeführt ist.

11. Gerät nach Anspruch 9 oder 10,
**dadurch gekennzeichnet, dass**
das Gehäuse des Geräts metallisch ist und das Steckverbinderteil ein mit dem Gerätegehäuse verbundenes metallisches Steckergehäuseteil umfasst, insbesondere zur Herstellung einer Erdverbindung für das Gehäuseteil,
und/oder dass
in das Steckverbinderteil auf einer der Leiterplatte abgewandten Seite ein Gegensteckverbinderteil einsteckbar ist, das mit einem außengeschirmten Kabel verbindbar ist, insbesondere zur hochfrequenzmäßig verbesserten Abschirmung,
und/oder dass
einer der Anschlussstifte (2) des Steckverbinderteils mit dem metallischen Steckergehäuseteil elektrisch verbunden ist, insbesondere wobei dieser Anschlussstift (2) weiter herausragt aus dem Steckverbinderteil als die anderen Anschlussstifte (2),
derart dass dieser Anschlussstift beim Lösen einer Steckverbindung mit einem Gegensteckverbinderteil als Letztes austritt und beim Herstellen der Steckverbindung als Erstes kontaktiert wird,
und/oder dass
das Steckverbinderteil ein Hybridsteckverbinderteil ist, welcher Anschlussstifte für Leistungsleitungen und Signalleitungen umfasst,
und/oder dass
das Gerät ein Frequenzumrichter oder ein Elektromotor ist,
und/oder dass
der Isolierkörper (5) und die Ausnehmungen im isolierenden Teil (7) derart asymmetrisch geformt sind, dass der Isolierkörper (5) nur bestimmungsgemäß in die Ausnehmung im isolierenden Teil einführbar ist.

12. Gerät nach einem der Ansprüche 9 bis 11, wobei
eine Unterbrechungsvorrichtung im Steckverbinderteil derart vorgesehen ist, dass der elektrische Kontakt der auf der Leiterplatte (1) lötverbundenen Anschlussstifte (2) zu Anschlussstiften (2) eines mit dem Steckverbinderteil verbundenen Gegensteckverbinderteils unterbrochen ist, solange der Isolierkörper (5) nicht in der Ausnehmung eingeführt und verbunden ist.

13. Verfahren zur Herstellung eines Geräts nach einem der Ansprüche 9 - 12, wobei
das Gerät ein Steckverbinderteil umfasst, das ein isolierendes Teil (7) umfasst, insbesondere ein Kunststoffteil, an dem eine Ausnehmung (6), insbesondere zweite Ausnehmung, ausgeformt ist,
wobei in dem isolierenden Teil Anschlussstifte (2) aufgenommen sind,
wobei die Anschlussstifte lötverbindbar mit Lötpads einer Leiterplatte (1) sind, wobei das Steckverbinderteil auf der Leiterplatte (1) lötverbunden wird, insbesondere in einem Schwalllötverfahren,
und danach der Isolierkörper (5) von der vom Steckverbinderteil abgewandten Seite der Leiterplatte (1) her kommend durch eine Ausnehmung in der Leiterplatte (1) in die Ausnehmung (6) des isolierenden Teils eingeführt wird und dann darin einklipsbar und/oder kraftschlüssig verbunden wird.

## Claims

1. A plug connector part,
comprising an insulating part (7), in particular a plastics part, in which a recess (6), in particular second recess, is formed,
wherein connecting pins (2) are received in the insulating part,
wherein the connecting pins can be solder-connected to solder pads of a printed circuit board (1),
wherein an insulating body (5) can be connected into the recess in the insulating part for increasing the air gap (4) between the connecting pins (2), **characterised in that**
the insulating body (5) can be clipped into the recess in the insulating part and/or connected with force fit.

2. The plug connector part according to Claim 1,
wherein the insulating part can be connected, in particular clipped, to a metal plug housing part and is at least partially surrounded in a housing-forming manner by said metal plug housing part.

3. The plug connector part according to Claim 2,
wherein the metal plug housing part can be connected, in particular screw-connected, to a corresponding metal plug housing part of a mating plug connector.

4. The plug connector part according to Claim 2 or 3,
wherein the metal plug housing part is provided earthed, in particular for high-frequency shielding and/or increasing safety.

5. The plug connector part according to at least one of the preceding claims,
wherein, on the side remote from the printed circuit board, the plug connector part is constructed for connection to a mating plug connector part, in particular as a bushing.

6. The plug connector part according to at least one of Claims 2 to 4,
wherein the metal plug housing part can be screwed into a device housing, in particular into a metal housing part for earthed connection.

7. A plug connection
**characterised in that**
it comprises a plug connector part according to at least one of the preceding claims.

8. The plug connection according to the preceding claim,
**characterised in that**
the plug connection is constructed as a circular plug connection with touch protection on both sides.

9. A device, comprising a plug connector part,
which comprises an insulating part, in particular a plastics part, in which a recess, in particular second recess, is formed,
wherein connecting pins (2) are received in the insulating part, wherein the connecting pins can be solder-connected to solder pads of a printed circuit board (1),
wherein
an insulating body (5) is provided plugged into the recess in the insulating part for increasing the air gap (4) between the connecting pins (2),
wherein the insulating body (5) projects through a printed circuit board (1) to which the plug connector part is at least solder-connected,
**characterised in that**
the insulating body (5) can be clipped into the recess (6) in the insulating part (7) and/or connected with force fit.

10. The device according to Claim 9,
wherein material of the insulating body (5) is provided between mutually adjacent connecting pins (2), in particular mutually closest-adjacent connecting pins (2),
and/or in that
the plug connector part is constructed according to one of claims 1 to 6.

11. The device according to Claim 9 or 10,
**characterised in that**
the housing of the device is metal and the plug connector part comprises a metal plug housing part connected to the device housing, in particular for producing an earthed connection for the housing part, and/or **in that**
a mating plug connector part, which can be connected to an externally shielded cable, can be plugged into the plug connector part on a side remote from the printed circuit board, in particular for improved high-frequency shielding,
and/or **in that**
one of the connecting pins (2) of the plug connector part is electrically connected to the metal plug housing part, in particular wherein this connecting pin (2) projects further out of the plug connector part than the other connecting pins (2),
such that this connecting pin is the last to emerge when a plug connection to a mating plug connector part is released and is the first to be contacted when the plug connection is produced,
and/or **in that**
the plug connector part is a hybrid plug connector part which comprises connecting pins for power lines and signal lines,
and/or **in that**
the device is a frequency converter or an electric motor,
and/or **in that**
the insulating body (5) and the recesses in the insulating part (7) are formed asymmetrically such that the insulating body (5) can only be inserted into the recess in the insulating part as intended.

12. The device according to one of Claims 9 to 11,
wherein an interruption device is provided in the plug connector part such that the electrical contact between the connecting pins (2) solder-connected on the printed circuit board (1) and connecting pins (2) of a mating plug connector part connected to the plug connector part is interrupted if the insulating body (5) is not inserted and connected in the recess.

13. A method for producing a device according to one of Claims 9-12, wherein the device comprises a plug connector part which comprises an insulating part (7), in particular a plastics part, in which a recess (6) in particular second recess, is formed,
wherein connecting pins (2) are received in the insulating part,
wherein the connecting pins can be solder-connected to solder pads of a printed circuit board (1), wherein the plug connector part is solder-connected on the printed circuit board (1), in particular in a flow soldering process,
and the insulating body (5) is subsequently inserted through a recess in the printed circuit board (1) into the recess (6) in the insulating part from that side of the printed circuit board (1) which is remote from the plug connector part and can then be clipped therein and/or is connected with force fit.

## Revendications

1. Partie de connecteur enfichable,
comprenant une partie isolante (7), en particulier une partie en matière plastique, sur laquelle est formé un évidement (6), en particulier un second évidement,
des broches de raccordement (2) étant logées dans la partie isolante,
les broches de raccordement pouvant être reliées par brasage à des pastilles de brasage d'une carte de circuits imprimés (1),
un corps isolant (5) pouvant être relié dans l'évidement de la partie isolante pour agrandir la distance dans l'air (4) entre les broches de raccordement (2), **caractérisée en ce que**
le corps isolant (5) peut être clipsé et/ou relié à force dans l'évidement de la partie isolante.

2. Partie de connecteur enfichable selon la revendication 1,
dans laquelle la partie isolante peut être reliée, en particulier clipsée à une partie boîtier de connecteur métallique qui l'entoure au moins partiellement en formant un boîtier.

3. Partie de connecteur enfichable selon la revendication 2,
dans laquelle la partie boîtier de connecteur métallique peut être reliée, en particulier par vissage, à une partie boîtier de connecteur métallique correspondante d'un connecteur enfichable complémentaire.

4. Partie de connecteur enfichable selon la revendication 2 ou 3,
dans laquelle la partie boîtier de connecteur métallique est prévue mise à la terre, en particulier pour le blindage contre les hautes fréquences et/ou pour augmenter la sécurité.

5. Partie de connecteur enfichable selon au moins l'une des revendications précédentes,
dans laquelle la partie de connecteur enfichable est conçue, du côté opposé à la carte de circuits imprimés, pour la liaison avec une partie de connecteur enfichable complémentaire, en particulier comme une douille.

6. Partie de connecteur enfichable selon au moins l'une des revendications 2 à 4,
dans laquelle la partie boîtier de connecteur métallique peut être vissée dans un boîtier d'appareil, en particulier pour la liaison à la terre dans une partie boîtier métallique.

7. Connexion enfichable
**caractérisée en ce qu'**elle comprend une partie de connecteur enfichable selon au moins l'une des revendications précédentes.

8. Connexion enfichable selon la revendication précédente,
**caractérisée en ce que** la connexion enfichable est réalisée sous la forme d'une connexion enfichable cylindrique protégée des deux côtés contre les contacts accidentels.

9. Appareil, comprenant une partie de connecteur enfichable
qui comprend une partie isolante, en particulier une partie en matière plastique, sur laquelle est formé un évidement, en particulier un second évidement,
des broches de raccordement (2) étant logées dans la partie isolante, les broches de raccordement pouvant être reliées par brasage à des pastilles de brasage d'une carte de circuits imprimés (1),
dans lequel
un corps isolant (5) est prévu inséré dans l'évidement de la partie isolante pour agrandir la distance dans l'air (4) entre les broches de raccordement (2),
le corps isolant (5) fait saillie à travers une carte de circuits imprimés (1) avec laquelle la partie de connecteur enfichable est reliée au moins par brasage, **caractérisé en ce que**
le corps isolant (5) peut être clipsé et/ou relié à force dans l'évidement (6) de la partie isolante (7).

10. Appareil selon la revendication 9,
dans lequel la matière du corps isolant (5) est prévue entre des broches de raccordement (2) proches les unes des autres, en particulier des broches de raccordement (2) les plus proches les unes des autres,
et/ou que
la partie de connecteur enfichable est réalisée selon l'une des revendications précédentes 1 à 6.

11. Appareil selon la revendication 9 ou 10,
**caractérisé en ce que**
le boîtier de l'appareil est métallique et la partie de connecteur enfichable comprend une partie boîtier de connecteur métallique reliée au boîtier d'appareil, en particulier pour réaliser une liaison à la terre pour la partie boîtier,
et/ou
qu'une partie de connecteur enfichable complémentaire peut être insérée dans la partie de connecteur enfichable d'un côté opposé à la carte de circuits imprimés et reliée à un câble à blindage extérieur, en particulier pour améliorer le blindage contre les hautes fréquences,
et/ou
qu'une des broches de raccordement (2) de la partie de connecteur enfichable est reliée électriquement à la partie boîtier de connecteur métallique, en particulier cette broche de raccordement (2) dépassant plus de la partie de connecteur enfichable que les autres broches de raccordement (2), de sorte que cette broche de raccordement sort en dernier lors de la rupture d'une connexion enfichable avec une partie de connecteur enfichable complémentaire et entre en contact en premier lors de l'établissement de la connexion enfichable
et/ou
que la partie de connecteur enfichable est une partie de connecteur enfichable hybride qui comprend des broches de raccordement pour des lignes de puissance et des lignes de signalisation,
et/ou
que l'appareil est un variateur de fréquence ou un moteur électrique,
et/ou
que le corps isolant (5) et les évidements dans la partie isolante (7) sont formés de manière asymétrique, de sorte que le corps isolant (5) ne peut être introduit dans l'évidement de la partie isolante que de manière conforme à sa destination.

12. Appareil selon l'une des revendications 9 à 11, dans lequel
un dispositif d'interruption est prévu dans la partie de connecteur enfichable, de sorte que le contact électrique des broches de raccordement (2) reliées par brasage sur la carte de circuits imprimés (1) avec les broches de raccordement (2) d'une partie de connecteur enfichable complémentaire reliée à la partie de connecteur enfichable est interrompue tant que le corps isolant (5) n'est pas introduit et relié dans l'évidement.

13. Procédé de fabrication d'un appareil selon l'une des revendications 9 à 12, lequel appareil comprend une partie de connecteur enfichable qui comprend une partie isolante (7), en particulier une partie en matière plastique, sur laquelle est formé un évidement (6), en particulier un second évidement,
des broches de raccordement (2) étant logées dans la partie isolante,
les broches de raccordement pouvant être reliées par brasage à des pastilles de brasage d'une carte de circuits imprimés (1), la partie de connecteur enfichable étant reliée par brasage sur la carte de circuits imprimés (1), en particulier par un procédé de brasage à la vague,
et dans lequel le corps isolant (5) est ensuite introduit dans l'évidement (6) de la partie isolante depuis le côté de la carte de circuits imprimés (1) opposé à la partie de connecteur enfichable à travers un évidement dans la carte de circuits imprimés (1) puis clipsé et/ou relié à force dans ledit évidement (6).
